# EUROPEAN PATENT APPLICATION

(11) **EP 4 671 475 A1**
(43) Date of publication of application: **31.12.2025**
(21) Application number: 25184786.9
(22) Date of filing: 24.06.2025
(51) Int. Cl.: E05D 3/04, B60L 53/30, E05D 9/00, H02B 1/38, H02G 3/08, H05K 5/00, E05D 3/02

(54) **HINGE SYSTEM AND CABINET**

(30) Priority: 26.06.2024 DE 102024118080
(71) Applicant: Eaton Intelligent Power Limited, D04 Y0C2 Dublin 4 (IE)
(72) Inventor: Manière, Jordy, 1033 Cheseaux-sur-lausanne (CH)
(74) Representative: Epping - Hermann - Fischer

(57) **Abstract**

A hinge system (100) for rotatably connecting a first cabinet element (201), a second cabinet element (202) and at least one third cabinet element (203) of a cabinet (1000) are specified, the hinge system (100) comprising a flag hinge element (1) comprising a shaft (10) with a first end (101) and a second end (102) and a first base plate (11) comprising a first hinge leaf (111) and a first hinge knuckle (112), the first hinge knuckle (112) being fixedly connected to the shaft (10), a second base plate (12) comprising a second hinge leaf (121) and a second hinge knuckle (122), the shaft (10) reaching through the second hinge knuckle (122), so that the second base plate (12) is arranged on the shaft (10) and is rotatably connected to the flag hinge element (1), at least one third base plate (13, 13') comprising a third hinge leaf (131, 131') and a third hinge knuckle (132, 132'), the shaft (10) reaching through the third hinge knuckle (132, 132'), so that the at least one third base plate (13, 13') is arranged on the shaft (10) and is rotatably connected to the flag hinge element (1), wherein the first hinge leaf (111) has at least one fastening hole (113) for fastening the first cabinet element (201) to the first base plate (11), wherein the second base plate (12) is a part of the second cabinet element (202), wherein the at least one third base plate (13, 13') is a part of the at least one third cabinet element (203).

Furthermore, a cabinet (1000) is specified.

## Description

A hinge system is specified. The hinge system can preferably be a hinge system for a cabinet. Furthermore, a cabinet with a hinge system is specified. Preferably, the cabinet has at least two door elements.

Cabinets with more than one door usually have individual hinges for every door. For instance, such cabinet has two hinges per door, so that every door must be mounted to the respective hinges by individual screws, which requires a certain amount of assembly time and costs.

At least one object of certain embodiments is to provide a hinge system. At least one further object of certain embodiments is to provide a cabinet.

These objects are achieved by the subject-matters according to the independent claims. Advantageous embodiments and developments are characterized in the dependent claims and are disclosed by the following description and the drawings.

According to at least one embodiment, a hinge system is provided. According to at least one further embodiment, a cabinet with at least one hinge system and preferably at least two hinge systems is provided. The features and embodiments described in the following apply to both the hinge system and the cabinet.

According to a further embodiment, the hinge system is configured for connecting at least two and preferably at least three cabinet elements. In particular, the cabinet can comprise at least a first cabinet element and a second cabinet element. Preferably, the cabinet comprises a first cabinet element, a second cabinet element and at least one third cabinet element. In particular, the cabinet elements can be rotatably connected to each other by the hinge system. "Rotatably connected" can, in particular, mean that cabinet elements can be rotated with respect to each other, for instance by an operator, around a rotation axis. In particular, one of the cabinet elements can be stationary, for instance fastened to a building wall, a floor or a post, while all other cabinet elements that a rotatably connected to the stationary cabinet element can be rotated with respect to the stationary cabinet element and to each other.

Each of the cabinet elements can comprise or be, for instance, a door element like a front door element or a middle door element or a cabinet box. Preferably, the cabinet can comprise at least one door element and a cabinet box or, preferably, at least two door elements and a cabinet box. Accordingly, the first cabinet element can be a door element. Particularly preferably, the first cabinet element is a front door element. Furthermore, the second cabinet element can be a cabinet box. The at least one third cabinet element can be a door element. Particularly preferably, the at least one third cabinet element is a middle door element. Moreover, the cabinet can comprise two or more third cabinet elements. In this case, preferably each of the third cabinet elements is a middle door element. Features and embodiments described in the following in regard to a third cabinet element can apply to all third cabinet elements, if more than one third cabinet elements are present.

A "front door element" can preferably denote an outermost door element of the cabinet that, when all door elements of the cabinet are closed, is visible and forms a front face of the cabinet. A "middle door element" can preferably denote a door element that, when all door elements of the cabinet are closed, is arranged behind a front door element. Accordingly, a front door element can be opened, while any middle door element remains closed, whereas a middle door element can only be opened at least together with a front door element or after the front door element has already been opened. Accordingly, the door elements can be opened and closed similar to the front cover and pages of a book.

The cabinet elements, in particular the cabinet box and the door elements, can enclose a cabinet space in which components can be arranged. For instance, the cabinet can be a housing for components for charging an electrical vehicle. Consequently, the cabinet can preferably be a part of a wallbox or can be a wallbox for charging an electrical vehicle.

According to a further embodiment, the hinge system comprises a flag hinge element comprising a first base plate and a shaft with a first end and a second end. In particular, the shaft has a main extension direction along an axis, which corresponds to the rotation axis around which cabinet elements can be rotated. The first end and the second end particularly denote the ends of the shaft along the rotation axis. The first base plate comprises a first hinge leaf and a first hinge knuckle, wherein the first hinge knuckle is fixedly connected to the shaft. Accordingly, the first base plate is fixedly connected to the shaft. In particular, the first hinge leaf and, thus, the first base plate can be permanently connected to the shaft via the first hinge knuckle, so that the first base plate cannot be removed from the shaft without at least partly destroying the first base plate and/or the shaft. For instance, the first base plate can comprise or be made of a plastic material like polyamide (PA). In particular, the plastic material can be glass-fiber-reinforced PA**.** Alternatively, other plastic materials are also possible. The shaft can comprise or be made of a metal material like stain-less steel. The first hinge leaf and the first hinge knuckle and, thus, the first base plate can be manufactured by molding the plastic material onto the shaft, thereby also manufacturing the flag hinge element.

According to a further embodiment, the first hinge leaf has at least one fastening hole for fastening the first cabinet element to the first base plate. Preferably, the first cabinet element is fastened to the first hinge leaf and, thus, to the first base plate by means of at least one screw connection. Particularly preferably, the first hinge leaf has at least one through-hole as fastening hole through which a screw can reach into a threaded hole of the first cabinet element. Furthermore, the first cabinet element is fastened to the first hinge leaf and, thus, to the first base plate, by means of two screw connections, so that the first hinge leaf has two fastening holes forms as through-holes, wherein a screw can reach through each of the fastening holes into a respective threaded hole formed in the first cabinet element. Alternatively, more than two screw connections are possible.

According to a further embodiment, the hinge system comprises a second base plate comprising a second hinge leaf and a second hinge knuckle. The shaft reaches through the second hinge knuckle, so that the second base plate is arranged on the shaft and is rotatably connected to the flag hinge element. In particular, the second base plate can be rotated around the rotation axis defined by the shaft of the flag hinge element. The second base plate can be a part of the second cabinet element or can be configured for being fastened to the second cabinet element, for instance by at least one screw connection. Particularly preferably, the second base plate comprises or is made from a plastic material and is an integral part of the second cabinet element. In other words, the second cabinet element has a region that is formed as the second base plate. In particular, the second base plate can be a part of a wall element or can be a wall element in case the second cabinet element is a cabinet box**.**

According to a further embodiment, the at least one third base plate comprises a third hinge leaf and a third hinge knuckle. The shaft reaches through the third hinge knuckle, so that the at least one third base plate is arranged on the shaft and is rotatably connected to the flag hinge element. In particular, the at least one third base plate can be rotated around the rotation axis defined by the shaft of the flag hinge element. The at least one third base plate can be a part of the third cabinet element or can be configured for being fastened to the third cabinet element, for instance by at least one screw connection. Particularly preferably, the third base plate comprises or is made from a plastic material and is an integral part of the third cabinet element. In other words, the third cabinet element has a region that is formed as the third base plate. In particular, the third base plate can be a part of a door element or can be a door element in case the at least one third cabinet element is a door element.

According to a further embodiment, the first base plate is arranged at the first end of the shaft. Accordingly, all further base plates of the hinge system, i.e. the second base plate and the at least one third base plate, are arranged on the side of first base plate that faces the second end of the shaft. Accordingly, the second hinge knuckle and the third hinge knuckle of the at least one third base plate can be arranged next to each other on the shaft. Furthermore, the second base plate can comprise a second hinge leaf and at least two second hinge knuckles, and the third base plate can comprise a third hinge leaf and at least two third hinge knuckles. The second hinge knuckles and the third hinge knuckles can be arranged on the shaft in an alternating manner. Consequently, the second base plate and at least one the third base plate can engage.

The first base plate can also be arranged at a distance to the first end and at a distance to the second end of the shaft. Accordingly, the second and third base plates of the hinge system can be arranged on different sides of the first base plate. In other words, the second base plate can for instance be arranged on the side of first base plate that faces the first end of the shaft, whereas the at least one third base plate can be arranged on the side of first base plate that faces the second end of the shaft, or vice versa.

According to a further embodiment, the cabinet comprises two hinge systems. In particular, the two hinge systems can be embodied similarly to each other. The first cabinet element can be fixedly fastened to the first base plate of the flag hinge element of each of the two hinge systems. The second cabinet element can comprise two second base plates and the at least one third cabinet element can comprise two third base plates. The shaft of the flag hinge element of each of the two hinge systems can reach through a second base plate of the second cabinet element and through a third base plate of the at least one third cabinet element, respectively. Particularly preferably, the second end of the shaft of one of the two hinge systems points towards the second end of the shaft of the other of the two hinge systems.

Further features, advantages and expediencies will become apparent from the following description of exemplary embodiments in conjunction with the figures.
- Figure 1: shows a schematic illustration of a hinge system according to an embodiment,
- Figures 2: to 4 show schematic illustrations of a flag hinge element of the hinge system shown in Figure 1,
- Figures 5: to 10 show schematic illustrations of a cabinet according to a further embodiment,
- Figures 11: and 12 show schematic illustrations of a hinge system according to further embodiments, and
- Figures 13: and 14 show schematic illustrations of a flag hinge element and a hinge system according to further embodiments.

In the figures, elements of the same design and/or function are identified by the same reference numerals. It is to be understood that the embodiments shown in the figures are illustrative representations and are not necessarily drawn to scale.

In order to give a thorough understanding, preferred embodiments of a hinge system, of components of the hinge system and of a cabinet with such hinge system are described in the following in connection with the figures. However, the described embodiments and combinations of features are not limiting. Alternatively or additionally to the features described in connection with the figures, the embodiments shown in the figures can comprise further features described in the general part of the description. Moreover, features and embodiments of the figures can be combined with each other, even if such combination is not explicitly described.

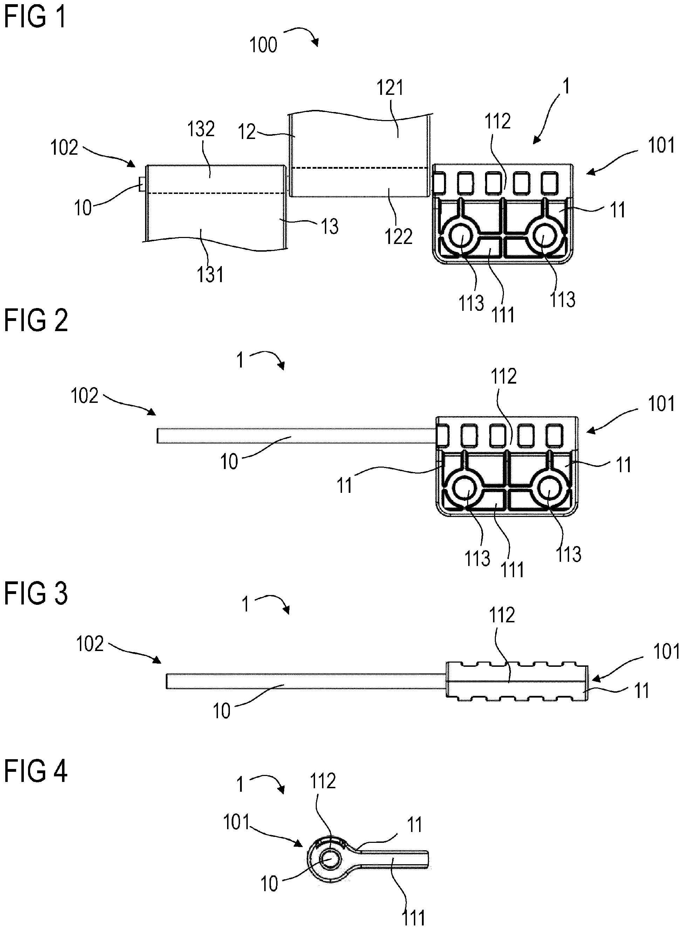

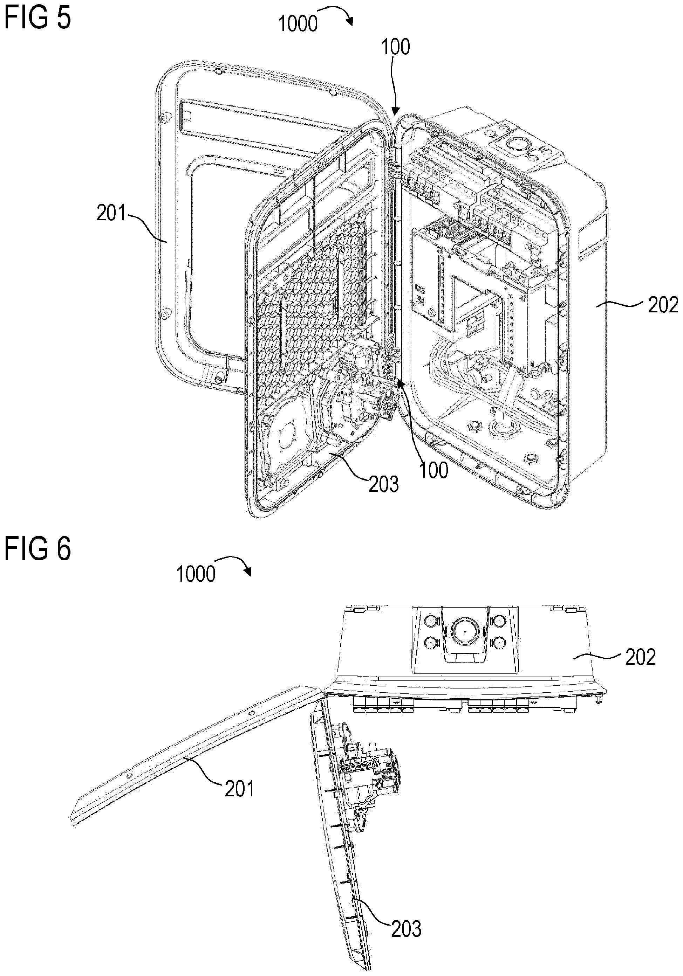

Figure 1 shows a schematic illustration of a hinge system 100 according to an embodiment. The shown hinge system 100 is configured for connecting three cabinet elements of a cabinet as described in detail further below in connection with Figures 5 to 10. In particular, the hinge system can rotatably connect said cabinet elements, so that cabinet elements of the cabinet can be rotated with respect to each other by an operator.

The hinge system 100 comprises a flag hinge element 1 that is shown in Figures 2 to 4 in different views. The flag hinge element 1 comprises a shaft 10 with a first end 101 and a second end 102. Furthermore, the flag hinge element 1 comprises a first base plate 11. The first base plate 11 comprises a first hinge leaf 111 and first hinge knuckle 112 that is fixedly connected to the shaft 10, so that the first base plate 11 is fixedly connected to the shaft 10. In particular, the first hinge knuckle 112 and, thus, the first base plate 11 are permanently connected to the shaft 10, so that the first base plate 11 cannot be removed from the shaft 10 without at least partly destroying the first base plate 11 and/or the shaft 10. In particular, the first base plate 11 is rigidly connected to the shaft 10, so that the first base 11 plate cannot be rotated or otherwise moved on the shaft 10. In particular, the shaft 10 reaches into the first hinge knuckle 112 of the first base plate 11, and the first hinge knuckle 112 is integrally connected with the first hinge leaf 111 and the shaft 10 is rigidly enclosed by the first hinge knuckle 112 so that the shaft 10 cannot move in the first hinge knuckle 112.

The first base plate 11 comprises or is preferably made of a plastic material like polyamide (PA). In particular, the plastic material can be glass-fiber-reinforced PA. Alternatively, other plastic materials are also possible that exhibit a sufficient mechanical stability for the functionality of the flag hinge element 1 as described herein. The shaft 10 comprises or is preferably made of a metal material like stain-less steel. The first hinge leaf 111 and, thus, the first base plate 11 is preferably manufactured by molding the plastic material onto the shaft 10, so that the flag hinge element 1 is assembled by molding the first base plate 11 onto the shaft 10.

In the shown embodiment, the first hinge leaf 111 has two fastening holes 113 for fastening a first cabinet element of the cabinet to the first base plate 11 as described below.

As depicted in Figure 1, the hinge system 100 further comprises a second base plate 12 comprising a second hinge leaf 121 and a second hinge knuckle 122. The shaft 10 reaches through the second hinge knuckle 122, so that the second base plate 12 is arranged on the shaft 10 and is rotatably connected to the flag hinge element 1. The second base plate 12 is preferably a part of a second cabinet element of the cabinet as described below. Particularly preferably, the second base plate 12 comprises or is made from a plastic material and is an integral part of the second cabinet element.

Furthermore, the hinge system 100 comprises a third base plate 13. The third base plate 13 comprises a third hinge leaf 131 and a third hinge knuckle 132. The shaft 10 reaches through the third hinge knuckle 132, so that the third base plate 13 is arranged on the shaft 10 and is rotatably connected to the flag hinge element 1. The third base plate 13 is preferably a part of a third cabinet element of the cabinet as described below. Particularly preferably, the third base plate 13 comprises or is made from a plastic material and is an integral part of the third cabinet element.

In the shown embodiment, the first base plate 11 is arranged at the first end 101 of the shaft 10. Accordingly, the further base plates of the hinge system 100, i.e. the second base plate 12 and the third base plate 13, are arranged on the side of first base plate 11 that faces the second end 102 of the shaft 10. Consequently, the second hinge knuckle 122 of the second base plate 12 and the third hinge knuckle 132 of the third base plate 13 are arranged next to each other on the shaft 10. By way of example, the second base plate 12 is arranged between the first base plate 11 and the third base plate 13. Alternatively, the third base plate 13 can be arranged between the first base plate 11 and the second base 12 plate. Further features and advantages of the hinge system 100 become apparent in connection with the following description.

Figures 5 to 10 show schematic illustrations of a cabinet 1000 according to a further embodiment that comprises two hinge systems 100 as described in connection with Figures 1 to 4. The cabinet 1000 further comprises a first cabinet element 201, a second cabinet element 202 and a third cabinet element 203, wherein the first cabinet element 201 and the third cabinet element 203 are door elements that can be opened and closed by rotation, and the second cabinet element 202 is a cabinet box.

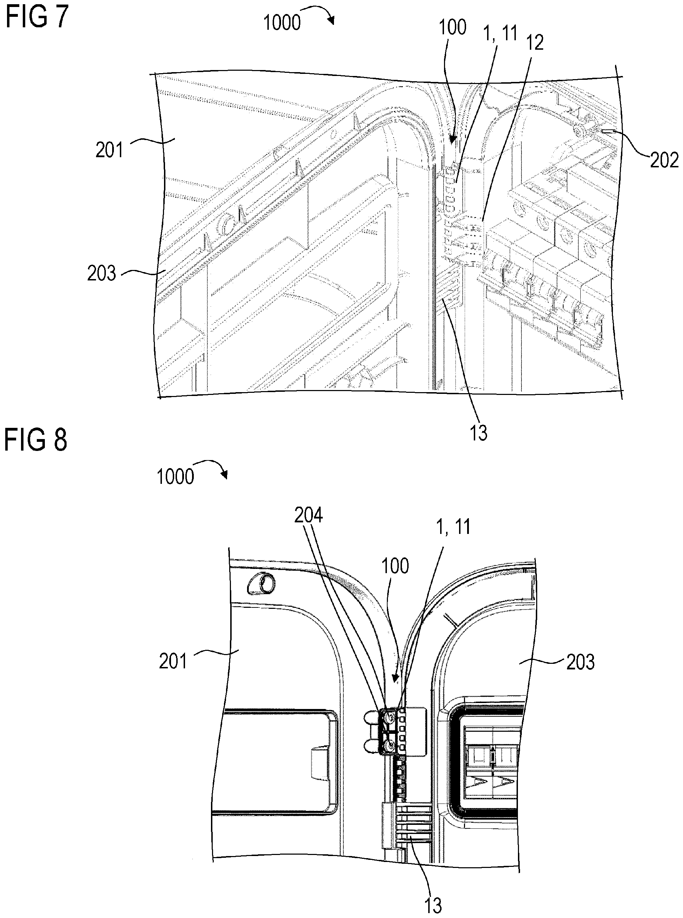

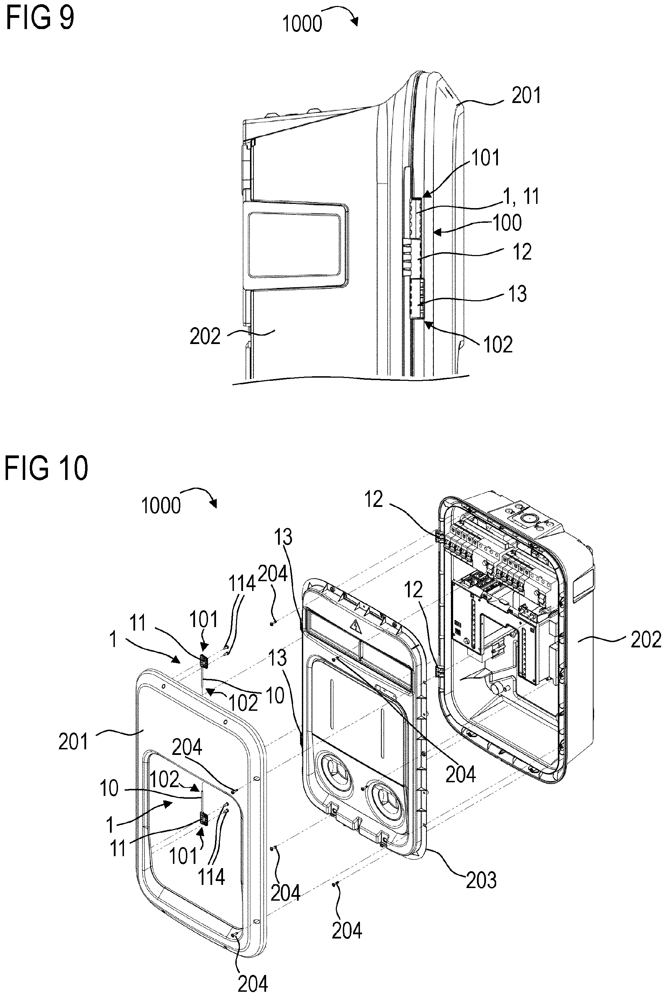

Figures 5 and 6 show in a three-dimensional view and in a top view the cabinet 1000 with the first cabinet element 201 in an opened state and the third cabinet element 203 in an opened state. Figures 7 and 8 each show in a three-dimensional view and in a vertical view parts of the cabinet 1000, wherein Figure 7 shows the first cabinet element 201 and the third cabinet element 203 in opened states, whereas Figure 8 shows the first cabinet element 201 in an opened state and the third cabinet element 203 in a closed state. Figure 9 shows in a lateral view a part of the cabinet 1000 in a closed stated. Figure 10 shows the cabinet 1000 in an exploded view. The following description equally applies to Figures 5 to 10 as well as to Figures 1 to 4 in connection with features of the hinge system 100.

In particular, the hinge systems 100 rotatably connect the cabinet elements, so that the cabinet elements can be rotated with respect to each other, for instance by an operator. The second cabinet element 202 is stationary and is, for instance, fastened to a building wall, a floor or a post, while the other cabinet elements, i.e. the first and third cabinet element201, 203, are rotatably connected to the stationary second cabinet element 202 and can be rotated with respect to the stationary second cabinet element 202. The two hinge systems 100 are embodied similarly to each other and are arranged symmetrically to each other. Consequently, the first ends 101 of the shafts 10 of the two hinge systems 100 face away from each other, whereas the second end 102 of the shaft 10 of one of the two hinge systems 100 points towards the second end 102 of the shaft 10 of the other of the two hinge systems 100.

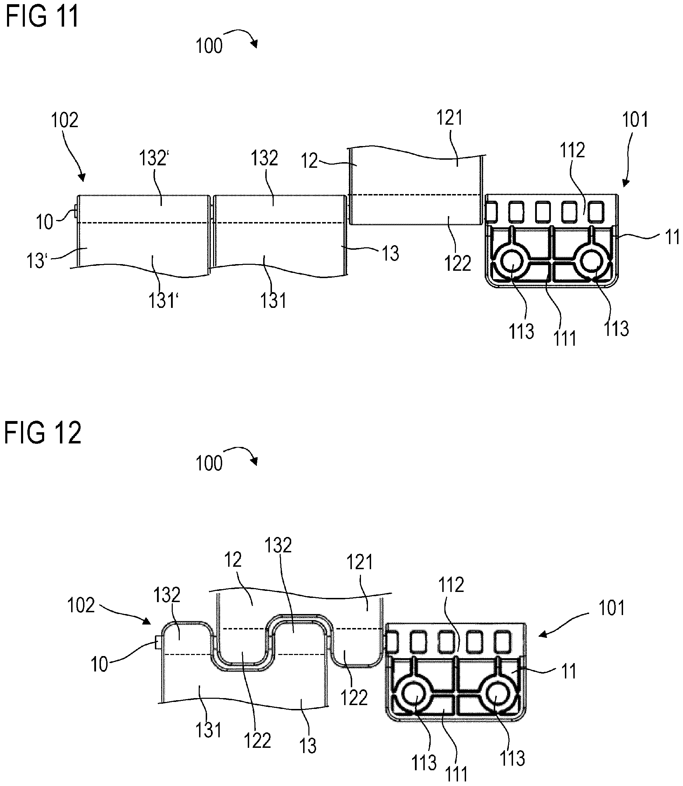

In the shown embodiment, the first cabinet element 201 is a front door element and the third cabinet element 203 is a middle door element. Moreover, the cabinet 1000 can comprise two or more third cabinet elements 203, in particular in connection with an embodiment of the hinge system 100 that is described below in connection with Figure 11. In this case, preferably each of the third cabinet elements 203 is a middle door element. Features and embodiments described in the following in regard to the shown single third cabinet element 203 can apply to all third cabinet elements 203, if more than one third cabinet elements 203 are present.

The first cabinet element 201 forming the front door element is the outermost door element of the cabinet 1000. Thus, the first cabinet element 201 is visible even when all door elements of the cabinet 1000 are closed and forms a front face of the cabinet. The third cabinet element 203 forming a middle door element is arranged behind the front door element when all door elements of the cabinet 1000 are closed. Accordingly, the first cabinet element 201 forming the front door element can be opened, while the third cabinet element 203 forming the middle door element can remain closed or can also be opened. However, the third cabinet element 203 forming the middle door element can only be opened together with the first cabinet element 201 or after the first cabinet element 201 has already been opened. As can be seen in Figure 10, the first cabinet element 201 and the third cabinet element 203 can each be secured to the second cabinet element 202 by means of screws 204, so that opening of the door elements by unauthorized persons can be prevented.

The cabinet elements 201, 202, 203, in particular the cabinet box and the door elements, can enclose a cabinet space in which components can be arranged. For instance, the cabinet 1000 can house components for charging an electrical vehicle. Consequently, the cabinet 1000 can be a part of a wallbox or can be a wallbox for charging an electrical vehicle. The first cabinet element 201 forming the front door element can be chosen according to its optical appearance. Furthermore, the first cabinet element 201 can cover parts of the cabinet components that are accessible when the first cabinet element 201 is opened while the third cabinet element 203 is still closed. Consequently, for a normal user like a vehicle driver who wants to recharge a vehicle the first cabinet element 201 is closed and only components are accessible that are meant to be used by the normal user. The first cabinet element 201 can be opened, for example, by an operator like a maintenance worker who wants to access control components that are accessible through the closed third cabinet element 203. By opening the third cabinet element 203, all interior components of the cabinet 1000 are accessible.

The first cabinet element 201 is fixedly fastened to the first base plate 11 of the flag hinge element 1 of each of the two hinge systems 100. Preferably, the first cabinet element 201 is fastened to the first hinge leaf 111 and, thus, to the first base plate 11 of each of the hinge systems 100 by means of screw connections. Particularly preferably, each of the first hinge leaves 111 has two through-holes as fastening holes 113 as explained above through which a respective screw 114 can reach into a threaded hole in the first cabinet element 201. Accordingly, only two screws 114 are needed in the shown embodiment for each hinge system 100 to connect the first cabinet element 201 to the hinge systems 100.

The second cabinet element 202 comprises two second base plates 12. The third cabinet element 203 comprises two third base plates 13. Each of the second base plates 12 and each of the third base plates 13 are associated with one of the two hinge systems 100. As described above, the second base plate 12 and the third base plate 13 of each of the hinge systems 100 comprise or are made from a plastic material. In particular, the second base plates 12 are integral parts of the second cabinet element 202 and the third base plates 13 are integral parts of the third cabinet element 203. In other words, the second cabinet element 202 has two regions that are formed as the second base plates 12 and the third cabinet element 203 has two regions that are formed as the third base plates 13. In particular, the second base plates 12 are parts of a wall element of the second cabinet element 202 forming the cabinet box, whereas the third base plates 13 are parts of the middle door element formed by the third cabinet element 203.

For assembling the cabinet 1000, the shaft 10 of the flag hinge element 1 of each of the two hinge systems 100 is inserted through a second base plate 12 of the second cabinet element 202 and through a third base plate 13 of the third cabinet element 203. Consequently, the third cabinet element 203 is mounted to the second cabinet element 202 by means of the flag hinge elements 1. Afterwards, the first cabinet element 201 can be fastened to the hinge system 100 by the screw 114 described before. Consequently, only four screws 114 are needed to fully assemble the cabinet elements 201, 202, 203 of the cabinet 1000. Furthermore, it is easily possible to exchange the front door element, i.e. the first cabinet element 201, for instance in case another optical appearance by using another door design is desired.

Figures 11 and 12 shows schematic illustrations of a hinge system according to further embodiments that are modifications to the hinge system as explained before. Accordingly, only differences to the previous embodiments are described in the following. Features that are not explicitly described can be embodied as described previously.

As shown in Figure 11, the hinge system 100 can comprise more than one third base plate 13. Consequently, a cabinet 1000 using the hinge system 100 can have more than one third cabinet elements 203 as mentioned above. By way of example only, the hinge system 100 of Figure 11 comprises two third base plates 13, 13', each comprising a third hinge leaf 131, 131' and a third hinge knuckle 132, 132', respectively. More than two third base plates 13, 13' are also possible. Furthermore, the third base plates 13, 13' can be arranged next to each other at the second end 102 of the shaft 10, all on one side of the second base plate 12, or the second base plate 12 can be arranged between third base plates 13, 13' or the third base plates 13, 13' can be arranged between the first base plate 11 and the second base plate 12.

According to the embodiment shown in Figure 12, the second base plate 12 comprises a second hinge leaf 121 and at least two second hinge knuckles 122, and the third base plate 13 comprises a third hinge leaf 131 and at least two third hinge knuckles 132. The second hinge knuckles 122 and the third hinge knuckles 132 are arranged on the shaft 10 in an alternating manner. Consequently, the second base plate 12 and the third base plate 13 can engage, which can increase the stability of the hinge system 100.

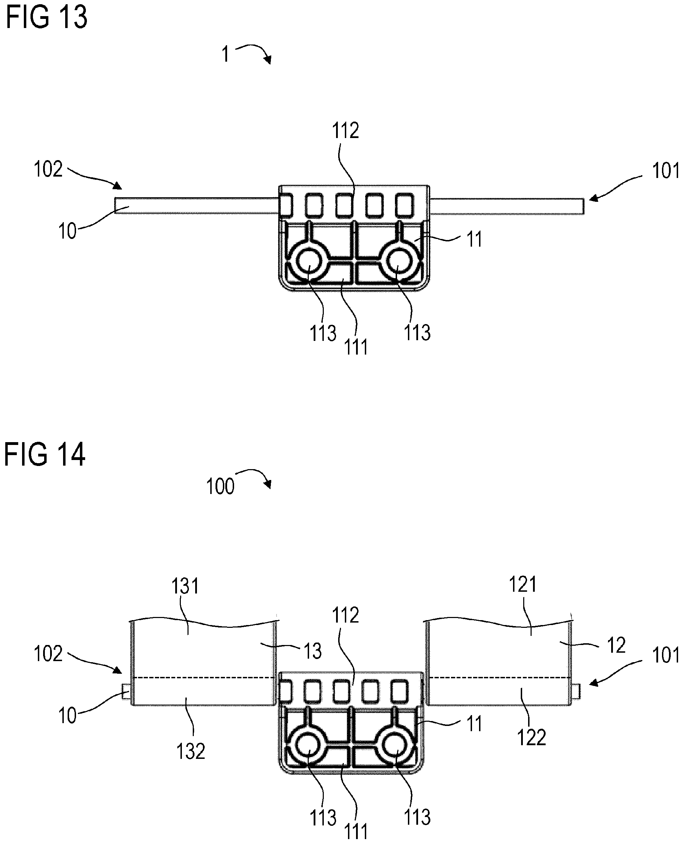

Figures 13 and 14 show schematic illustrations of a flag hinge element 1 and a hinge system 100 according to further embodiments, in which the first base plate 11 is arranged at a distance to the first end 101 and at a distance to the second end 102 of the shaft 10. Accordingly, the other base plates of the hinge system 100, i.e. the second base plate 12 and the third base plate 13 in the shown embodiment, can be arranged on different sides of the first base plate 11. In other words, the second base plate 12 can for instance be arranged on the side of first base plate 11 that faces the first end 101 of the shaft 10, whereas the third base plate 13 can be arranged on the side of first base plate 11 that faces the second end 102 of the shaft 10, or vice versa.

The invention is not restricted by the description on the basis of the exemplary embodiments. Rather, the invention encompasses any new feature and also any combination of features, which in particular comprises any combination of features in the patent claims, even if this feature or this combination itself is not explicitly specified in the patent claims or exemplary embodiments.

### Reference numerals

- 1: flag hinge element
- 10: shaft
- 11: first base plate
- 12: second base plate
- 13, 13': third base plate
- 100: hinge system
- 101: first end
- 102: second end
- 111: first hinge leaf
- 112: first hinge knuckle
- 113: fastening hole
- 114: screw
- 121: second hinge leaf
- 122: second hinge knuckle
- 131, 131': third hinge leaf
- 132, 132': third hinge knuckle
- 201: first cabinet element
- 202: second cabinet element
- 203: third cabinet element
- 204: screw
- 1000: cabinet

## Claims

1. Hinge system (100) for rotatably connecting a first cabinet element (201), a second cabinet element (202) and at least one third cabinet element (203) of a cabinet (1000), the hinge system (100) comprising
- a flag hinge element (1) comprising a shaft (10) with a first end (101) and a second end (102) and a first base plate (11) comprising a first hinge leaf (111) and a first hinge knuckle (112), the first hinge knuckle (112) being fixedly connected to the shaft (10),
- a second base plate (12) comprising a second hinge leaf (121) and a second hinge knuckle (122), the shaft (10) reaching through the second hinge knuckle (122), so that the second base plate (12) is arranged on the shaft (10) and is rotatably connected to the flag hinge element (1),
- at least one third base plate (13, 13') comprising a third hinge leaf (131, 131') and a third hinge knuckle (132, 132'), the shaft (10) reaching through the third hinge knuckle (132, 132'), so that the at least one third base plate (13, 13') is arranged on the shaft (10) and is rotatably connected to the flag hinge element (1),
wherein the first hinge leaf (111) has at least one fastening hole (113) for fastening the first cabinet element (201) to the first base plate (11),
wherein the second base plate (12) is a part of the second cabinet element (202),
wherein the at least one third base plate (13, 13') is a part of the at least one third cabinet element (203).

2. Hinge system (100) according to claim 1, wherein the first base plate (11) is arranged at the first end (101) of the shaft (10).

3. Hinge system (100) according to claim 1, wherein the first base plate (11) is arranged at a distance to the first end (101) of the shaft (10) and at a distance to the second end (102).

4. Hinge system (100) according to any one of the preceding claims, wherein
- the second base plate (12) comprises at least two second hinge knuckles (122).

5. Hinge system (100) according to any one of the preceding claims, wherein the at least one third base plate (13, 13') comprises at least two third hinge knuckles (132, 132').

6. Hinge system (100) according to claim 4 and 5, wherein the second base plate (12) and at least one the third base plate (13) engage.

7. Hinge system (100) according to any one of the preceding claims, wherein the first base plate (11) comprises a plastic material and the shaft (10) comprises a metal.

8. Hinge system (100) according to any one of the preceding claims, wherein the second base plate (12) and/or the at least one third base plate (13, 13') comprises a plastic material.

9. Cabinet (1000), comprising
- two hinge systems (100) according to any one of the preceding claims,
- a first cabinet element (201),
- a second cabinet element (202) comprising two second base plates (12) and
- at least one third cabinet element (203) comprising two third base plates (13, 13'),
wherein
- the first cabinet element (201) is fixedly fastened to the first base plate (11) of the flag hinge element (1) of each of the two hinge systems (100),
- the shaft (10) of the flag hinge element (1) of each of the two hinge systems (100) reaches through a second base plate (12) of the second cabinet element (202) and through a third base plate (13) of the at least one third cabinet element (203).

10. Cabinet (1000) according to claim 9, wherein the second end (102) of the shaft (10) of one of the two hinge systems (100) points towards the second end (102) of the shaft (10) of the other of the two hinge systems (100).

11. Cabinet (1000) according to claim 9 or 10, wherein the first cabinet element (201) and the at least one third cabinet element (203) are door elements.

12. Cabinet (1000) according to claim 11, wherein the first door element is a front door element and the at least one third cabinet element (203) is a middle door element.

13. Cabinet (1000) according to any one of the claims 9 to 12, wherein the second cabinet element (202) is a cabinet box.

14. Cabinet (1000) according to any one of the claims 9 to 13, wherein the first cabinet element (201) is fixedly fastened to the first base plates (11) by screw connections.

15. Cabinet (1000) according to any one of the claims 9 to 14, wherein the cabinet (1000) is a wallbox.
